# EUROPÄISCHE PATENTSCHRIFT

(11) **EP 0 976 181 B1**
(45) Veröffentlichungstag und Bekanntmachung des Hinweises auf die Patenterteilung: **05.12.2001**
(21) Anmeldenummer: 98928149.8
(22) Anmeldetag: 06.04.1998
(51) Int. Cl.: H01R 27/02, H01R 31/00

(54) **MODUL ZUM ANSCHLUSS VON AKTOREN UND/ODER SENSOREN**
MODULE FOR CONNECTING ACTUATORS AND/OR SENSORS
MODULE POUR CONNECTER DES ACTIONNEURS ET/OU DES DETECTEURS

(30) Priorität: 17.04.1997 DE 19716137
(43) Veröffentlichungstag der Anmeldung: 02.02.2000
(73) Patentinhaber: SIEMENS AKTIENGESELLSCHAFT, 80333 München (DE)
(72) Erfinder: HUSSONG, Wolfgang, D-91080 Uttenreuth (DE); FREIMUTH, Michael, D-92242 Hirschau (DE); SCHATZ, Wolfgang, D-92224 Amberg (DE)
(86) Internationale Anmeldenummer: DE9800974
(87) Internationale Veröffentlichungsnummer: WO9848489

(56) Entgegenhaltungen:
- EP-A- 0 473 336
- EP-A- 0 740 365
- WO-A-94/24725
- DE-C- 19 606 481

## Beschreibung

Die Erfindung bezieht sich auf ein Modul zum Anschluß von Aktoren und/oder Sensoren mit einem auf ein Unterteil aufsetzbaren Gehäuse, das eine Kontaktierungseinrichtung mit Kontaktstiften aufweist. Ein derartiges Modul ist aus der WO 94/24 725 bekannt.

Derartige, am Elektromarkt beziehbare Module weisen standardisierte Außenabmessungen und Befestigungslochbilder sowie Teilnehmerabgänge auf. Auf z.B. Leiterplatten realisierte elektrische Schaltungen der Module sind in einem Gehäuse eingebaut, das vor Ort montiert wird. So sind z.B. in einer Fertigungsinsel der Automobilindustrie eine Anzahl solcher Module positioniert. Dabei werden dem oder jedem Modul über ein Kabel beispielsweise eine Hilfsspannung und Steuersignale (Aktor/Sensor-Interfacebus) zugeführt, die über die Teilnehmerabgänge des Moduls in Form von Aktor- oder Sensorausgängen abgegriffen oder über entsprechende Eingänge in dieses eingespeist werden können. So kann beispielsweise ein Sensorsignal einer Lichtschranke als Eingangssignal einem Eingang des Moduls zugeführt werden, während über einen Ausgang des Moduls z.B. ein Aktor in Form eines Relais mit der Hilfsspannung und/oder mit Steuersignalen beaufschlagt werden kann.

Dabei erfolgt die Hilfsspannungs- und Steuersignalzuführung zum Modul üblicherweise über zwei Flachkabel, die nach erfolgter Positionierung und Montage des Moduls an dieses angeschlossen werden. Über am Gehäuse des Moduls vorgesehene Anschlußdome, deren Kontakte mit der innerhalb des Gehäuses angeordneten Leiterplatte entsprechend der jeweiligen elektrischen Schaltung verbundenen sind, können Verbindungen zu den jeweiligen Teilnehmern hergestellt werden. Der Einsatz von Flachkabeln hat sich jedoch insbesondere dort als äußerst problematisch herausgestellt, wo extreme äußere Bedingungen vorliegen. So werden beispielsweise in Schweißstraßen der metallverarbeitenden Industrie die Flachkabel, insbesondere an deren Ecken, durch glühende Schweißperlen zerstört.

Die Erfindung geht von der Erkenntnis aus, daß Rundkabel gegen derartige extreme äußere Bedingungen widerstandsfähig sind. Der Erfindung liegt daher die Aufgabe zugrunde, ein Modul der oben genannten Art anzugeben, das bei einfachem Aufbau die Kontaktierung auch eines Rundkabels sowie die Montage und den Service auf einfache Weise ermöglicht.

Diese Aufgabe wird erfindungsgemäß dadurch gelöst, daß das Unterteil ein das Gehäuse überragendes Aufnahmeteil mit einer Aufnahmeöffnung für eine mit einem Verbindungsteil kontaktierbare Steckerkupplung eines Rundkabelanschlusses aufweist, wobei das Verbindungsteil mit den Kontaktstiften in Eingriff bringbare Kontaktelemente aufweist. Dabei wird unter Rundkabelanschluß ein eckiger oder runder Steckeranschluß, insbesondere für einen Rechteckstecker bzw. für einen Rundstecker, verstanden.

In vorteilhafter Ausgestaltung ist das Aufnahmeteil an einem Freiende des Unterteils angeformt. Dieser Formansatz ist zweckmäßigerweise in Modullängsrichtung konisch ausgebildet, wobei die Aufnahmeöffnung für die Steckerkupplung quer zur Ebene des Unterteils verläuft. Dabei weist das Außenteil vorzugsweise an dessen konischen Freiende eine an die Aufnahmeöffnung angepaßte, abgerundete Außenkontur auf.

Um die aus dem Gehäuse herausragenden Kontaktstifte, d.h. die elektrische Verbindung vom Modul zum bisher vorgesehenen Flachkabel, und alle mechanischen und konstruktiven Eigenschaften des Gehäuses unverändert übernehmen zu können, ist das Verbindungsteil zweckmäßigerweise eine Kontaktplatte, die einerseits die Kontaktelemente und andererseits Anschlußelemente für die Steckerkupplung trägt. Dabei ist die Kontaktplatte - und damit das Verbindungsteil - derart ausgestaltet, daß im Montagezustand die Kontaktelemente mit den Kontaktstiften oder Kontaktspießen korrespondieren. Das Verbindungsteil bildet somit quasi einen Adapter für den Anschluß von Rundkabeln unterschiedlicher mechanischer Abmessungen und Aderverseilungen, die dazu in einfacher Weise auf die Steckerkupplung gesteckt werden.

Das Verbindungsteil in Form der die Steckerkupplung tragenden Kontaktplatte ist vorzugsweise von unten her gegen die Unterseite des Unterteils montierbar, wobei an der Oberseite des Unterteils im Kontaktierungsbereich zu den Kontaktstiften einerseits und zu den Kontaktelementen des Verbindungsteils andererseits korrespondierende Öffnungen vorgesehen sind. Durch diese Öffnungen werden dann bei der Montage die Kontaktstifte zur Kontaktierung mit den Kontaktelementen hindurchgeführt.

In zweckmäßiger Ausgestaltung sind die Kontaktelemente in Form von Flachfederelementen oder Kelchfedern ausgebildet. Alternativ kann als Kontaktelement ein Leiterabschnitt vorgesehen sein, der in einer im Kontaktierungsbereich vorgesehenen Aufnahmenut positioniert ist. Diese Aufnahmenut ist zweckmäßigerweise auf der Oberseite des Unterteils, d. h. im Kontaktierungsbereich, vorgesehen. Alternativ kann die oder jede Aufnahmenut auch in der Kontaktplatte und somit im Verbindungsteil vorgesehen sein.

Um eine besonders hohe Schutzart, z.B. IP67, zu erreichen, ist zur Abdichtung des Kontaktierungsbereiches auf der Oberseite des Unterteils eine Ausnehmung für eine Flachdichtung vorgesehen. Innerhalb dieser Ausnehmung ist dann auch die oder jede Aufnahmenut für den jeweiligen Leiterabschnitt vorgesehen.

Um auch weiterhin ein oder mehrere Flachkabel an das Modul anschließen zu können, weist vorteilhafterweise das Unterteil längsseitig am Kontaktierungsbereich zusätzlich mindestens eine an die Außenkontur des Flachkabels angepaßte Aufnahmenut mit Kontaktstiften zur stirnseitigen Kontaktierung des Flachkabels auf.

Für eine besonders einfache Montage und positionssichere Kontaktierung im Kontaktierungsbereich sind das Unterteil und das Gehäuse schwenkmontierbar gehalten. Zur Bildung eines entsprechenden Schwenkmittels sind am Unterteil angeformte Einhängevorrichtungen in Form von Haken und am Gehäuse angeformte und daran angepaßte Gegenstücke vorgesehen. Dies ermöglicht während der Montage in einem ersten Montageschritt die Anbringung des oder jedes Unterteils am vorgesehenen Ort, woraufhin in einem zweiten Montageschritt die den jeweiligen Unterteilen zugeordneten Gehäuse mit den Teilnehmeranschlüssen auf dessen Oberseite und mit den Kontaktstiften auf dessen Unterseite auf das jeweilige Unterteil in einfacher Weise aufgeschwenkt werden können. Um ein Verwechseln unterschiedlicher Gehäusevarianten zu verhindern, ist zwischen dem Gehäuse und dem Unterteil eine mechanische Kodierung in Form eines Kodierungssteckers vorgesehen. Dieser trägt bei der Erstmontage eine entsprechende Kodierbuchse, die im Anschluß an diese Erstmontage in einer korrespondierenden Öffnung im Unterteil verankert ist und somit dort unverlierbar verbleibt.

Die mit der Erfindung erzielten Vorteile bestehen insbesondere darin, daß durch eine Separierung des Unterteils vom die eigentliche elektrische Schaltung enthaltenden Gehäuse dieses unverändert weiterverwendet werden kann, da die für den Anschluß eines Rundkabels erforderliche Kabelaufnahme und Verbindung zu der elektrischen Schaltung über die Kontaktstifte allein im Unterteil realisiert ist. Daher müssen bei bereits installierten Modulen lediglich die Unterteile gegen diese für einen Rundkabelanschluß ausgelegten Unterteile ausgetauscht werden, während die jeweiligen Gehäuse weiterverwendbar sind.

Das Modul kann somit in rauher Industrieumgebung mit hoher Schutzart betrieben werden. Über die zusätzliche Kontaktstelle können weiterhin Flachkabel angeschlossen werden, so daß sich bei Bedarf ein Übergang von Rund- auf Flachkabel erstellen läßt, ohne daß es hierfür einer besonderen Baugruppe bedarf.

Ausführungsbeispiele der Erfindung werden anhand einer Zeichnung näher erläutert. Darin zeigen:
- FIG 1: in perspektivischer Darstellung ein Modul zum Anschluß von Aktoren und/oder Sensoren mit einem Rundkabelanschluß,
- FIG 2: in perspektivischer längsseitiger Unteransicht das Modul gemäß FIG 1 vor dem Aufsetzten seines Gehäuses auf sein Unterteil,
- FIG 3: in perspektivischer Aufsicht das Unterteil gemäß FIG 2 und ein Verbindungsteil für einen Rundkabelanschluß vor dessen Einsetzen in das Unterteil,
- FIG 4: ein Unterteil gemäß FIG 3 mit Kontaktstellen für Flachkabel, und
- FIG 5: alternative Ausführungen von Kontaktelementen des Verbindungsteils.

Einander entsprechende Teile sind in allen Figuren mit den gleichen Bezugszeichen versehen.

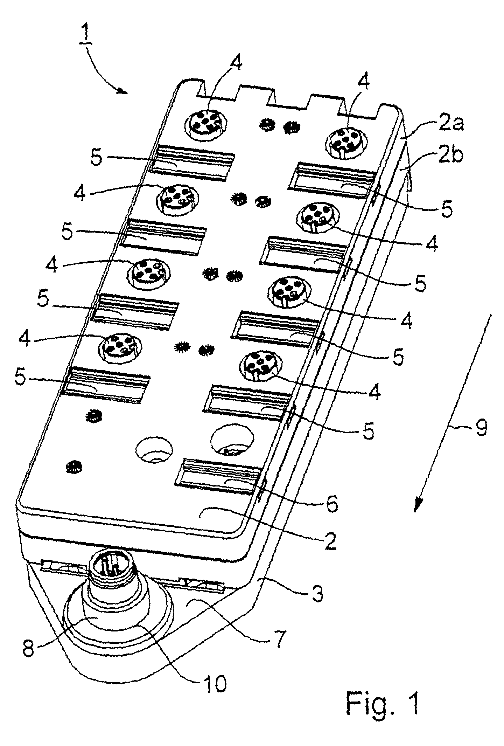

FIG 1 zeigt ein Modul 1 zum Anschluß mehrerer Teilnehmer, z.B. zum Anschluß von Sensoren und/oder Aktoren. Das Modul 1 dient zum Datenaustausch der Teilnehmer mit einem entfernt gelegenen Master. Als Verbindung zum Master wird ein Bussystem, vorzugsweise eine Rundkabelleitung, an das Modul 1 angeschlossen. Das Modul 1 umfaßt ein aus einem Gehäuseoberteil 2a und einem Gehäuseunterteil 2b zusammengesetztes Gehäuse 2 sowie ein Unterteil 3 in der Art einer Montageplatte. Das Gehäuse 2 weist einen Innenraum auf, in dem in nicht näher dargestellter Art und Weise eine Leiterplatte mit einer elektrischen Schaltung gelagert ist.

Über Teilnehmeranschlüsse 4 ist die elektrische Verbindung zum Teilnehmer mit der Schaltung herstellbar. Die Teilnehmeranschlüsse 4 bilden Eingänge und/oder Ausgänge des Moduls 1. Die Teilnehmeranschlüsse 4 sind handelsübliche Steck-Schraubanschlüsse mit kodierten Steckerdomen zum Anschluß der Teilnehmer, d.h. der Aktoren und/oder Sensoren. Die Teilnehmeranschlüsse 4 sind in einem ausreichenden Abstand voneinander derart angeordnet, daß gerade und abgewinkelte Stecker mit angespritzten Leitungen, wie auch Stecker mit frei zugänglichen Anschlußklemmen angeschlossen werden können. In den Steckerdomen befinden sich jeweils bis zu fünf Kontaktbuchsen, die in der Leiterplatte eingelötet sind. Zur eindeutigen Zuordnung zu den Teilnehmeranschlüssen oder Steckerdomen 4 sind Schilderausnehmungen 5 für Bezeichnungsschilder vorgesehen. Eine weitere Schilderausnehmung 6 dient zur Aufnahme eines das Modul 1 selbst kennzeichnenden Bezeichnungsschildes.

Das Unterteil 3 ist mit einem Aufnahmeteil 7 zur Aufnahme einer Steckerkupplung 8 für den Anschluß eines (nicht dargestellten) Rundkabels versehen. Dazu ist das Aufnahmeteil 7 an einem Freiende des Unterteils 3 angeformt und in Modullängsrichtung 9 konisch ausgebildet. Dabei verläuft eine AufnahmeÖffnung 10 für die Steckerkupplung 8 quer zur Ebene des Unterteils 3. Die Außenkontur des Aufnahmeteils 7 ist auf der dem Gehäuse 2 abgewandten Seite an die Kreisform der Aufnahmeöffnung 10 angepaßt. Diese abgerundete Konusform des Aufnahmeteils 7 ist besonders ergonomisch und zu dem materialsparend.

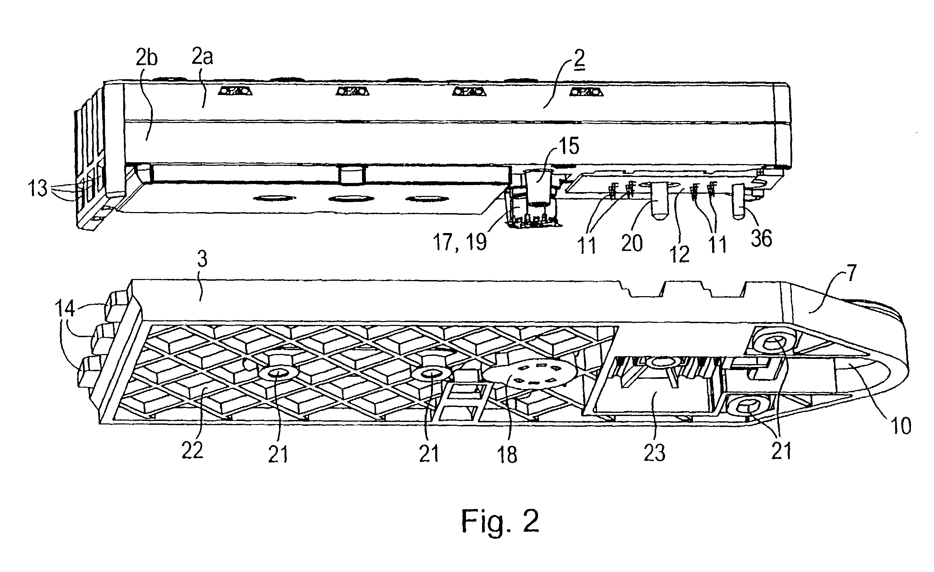

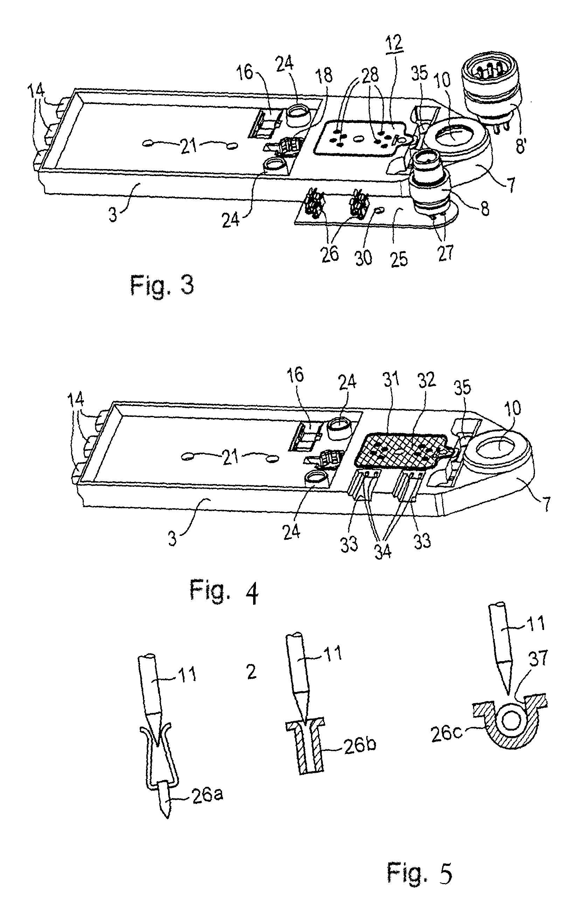

Wie FIG 2 zeigt, ragen auf der Unterseite des Gehäusebodens 2b Kontaktstifte 11 in einem Kontaktierungsbereich 12 aus dem Gehäuse 2 heraus, die innerhalb des Gehäuses 2 in nicht näher dargestellter Art und Weise an die Leiterplatte angeschlossen sind. Diese spitzen Kontaktstifte 11 einer Kontaktierungseinrichtung sind mittels Durchdringungstechnik mit korrespondierenden Kontaktelementen (FIG 3) kontaktierbar.

Zur schwenkmontierbaren Halterung des Gehäuses 2 am Unterteil 3 sind stirnseitig am Gehäuse 2 Einhängevorrichtungen 13 angeformt, die mit am Unterteil 3 angeformten Gegenstücken 14 in Form von Haken in Eingriff gebracht werden können. Durch Schwenken des Gehäuses 2 um die als Drehachse oder Schwenkachse wirkenden Einhängevorrichtungen 13 wird das Gehäuse 2 auf das Unterteil 3 aufgesetzt. Dazu greifen am Gehäuseboden 2b vorgesehene Führungsbolzen 15 in korrespondierende Öffnungen (FIG 3) im Unterteil 3.

Um bei Reparatur oder Austausch des Gehäuses 2 ein Verwechseln unterschiedlicher Varianten zu verhindern, ist zwischen dem Gehäuse 2 und dem Unterteil 3, das ebenfalls eine Schildausnehmung 16 für ein modulspezifisches Bezeichnungsschild aufweist, eine mechanische Kodierung angebracht. Dazu greift ein ebenfalls am Gehäuseboden 2b vorgesehener Kodierungsstecker 17 in eine korrespondierende Öffnung 18 im Unterteil 3. Bei der Erstmontage trägt der Kodierungsstecker 17 auch eine entsprechende Kodierbuchse 19, die nach der Erstmontage in der korrespondierenden Öffnung 18 des Unterteils 3 einrastet und anschließend dort unverlierbar gehalten ist. Beim Abnehmen des Gehäuses 2 vom Unterteil 3 verbleibt somit die Buchse 19 im Unterteil 3, so daß aufgrund der Kodierung bei einer erneuten Montage nur stets dasselbe Gehäuse 2 auf dieses Unterteil 3 aufsetzbar ist. Eine im Kontaktierungsbereich 12 zentral angeordnete Schraube 20 zur Befestigung oder Verriegelung zieht dabei das Gehäuse 2 auf das Unterteil 3. Die schwenkmontierbare Halterung mit den in die Einhängevorrichtung 13 eingreifenden Haken 14 hält das Gehäuse 2 auf dem Unterteil 3 fest.

Das Unterteil 3 ist im Bereich außerhalb des Aufnahmeteils 7 derart ausgeführt, daß deren Grundabmessungen und deren Lochbild zum Befestigen des Moduls 1 den auf dem Markt gängigen Modulen entspricht. Bohrungen 21 im Unterteil 3 ermöglichen eine Anpassung des Moduls 1 auch an ein anderes Befestigungsschema. Durch Bereitstellung mehrerer gängiger Befestigungslochbilder wird die Kompatibilität mit anderen Modulen erhöht und damit dessen Einsatzmöglichkeit verbessert. Zur Stabilisierung des Unterteils 3 ist dessen Boden mit einem wabenförmigen Stegmuster 22 versehen. Bodenseitig, d. h. auf der dem Kontaktierungsbereich 12 gegenüberliegenden Seite des Unterteils 3 weist dieses eine Ausnehmung 23 für ein in FIG 3 dargestelltes Verbindungselement auf.

FIG 3 zeigt das Unterteil 3 in einer Draufsicht, wobei dort zwei Buchsen 24 für die korrespondierenden Führungsbolzen 15 des Gehäuses 2 sowie die Aufnahmebuchse 18 für den Kodierstecker 17 bzw. die zugehörige Buchse 19 sichtbar sind. Ebenfalls sichtbar sind zwei der Bohrungen 21 zur Befestigung des Unterteils 3 an dessen Bestimmungsort.

Ein in der FIG 3 vom Unterteil 3 separiertes und getrennt dargestelltes Verbindungsteil 25 in Form einer Kontaktplatte trägt einerseits zu den Kontaktstiften 11 korrespondierende Kontaktelemente 26 und andererseits die Steckerkupplung 8. Deren Kontaktfüße oder Anschlußpins 27 sind in nicht näher dargestellter Art und Weise auf der Unterseite des Verbindungsteils 25 mit den jeweiligen Kontaktelementen 26 elektrisch leitend verbunden.

Beim Einbau der Kontaktplatte oder des Verbindungsteils 25 wird dieses von unten gegen das Unterteil 3 und in die Ausnehmung 23 geführt, so daß die Steckerkupplung 8 im eingebauten Zustand des Verbindungsteils 25 durch die Aufnahmeöffnung 10 hindurchgeführt und dabei teilweise aus dieser herausgeführt ist (FIG 1). Gleichzeitig sind die Kontaktelemente 26 derart positioniert, daß diese mit Öffnungen 28 im Unterteil 3 im Kontaktierungsbereich 12 korrespondieren. Durch diese Öffnungen 28 dringen beim Aufschwenken des Gehäuses 2 auf das Unterteil 3 die Kontaktstifte 11 zur Kontaktierung mit den Kontaktelementen 26 hindurch. Eine zur Aufnahme der Schraube 20 im Kontaktierungsbereich 12 ebenfalls zentral angeordnete Öffnung 29 ist im Verbindungsteil 25 als Öffnung 30 weitergeführt.

Der Kontaktierungsbereich 12 des Unterteils 3 ist mit einer Ausnehmung 31 zur Aufnahme einer in FIG 4 als Schraffur dargestellten Flachdichtung 32 versehen. Die Flachdichtung 32, in der alle im Kontaktierungsbereich 12 vorgesehenen Öffnungen 28, 29 ebenfalls vorhanden sind, dichtet dabei den gesamten Kontaktierungsbereich 12 ab.

FIG 4 zeigt das Unterteil 3 mit im Kontaktierungsbereich 12 zwei Aufnahmenuten 33 mit Kontaktspießen 34 zur stirnseitigen Kontaktierung zweier (nicht dargestellter) Flachkabel. Die Kontaktspieße 34 sind in nicht näher dargestellter Art und weise mit den Kontaktelementen 26 des Verbindungsteils 25 elektrisch leitend verbunden. Eine zwischen dem Kontaktierungsbereich 12 und der Aufnahmeöffnung 10 liegende U-förmige Ausnehmung 35 dient zur Aufnahme eines (nicht dargestellten) Kontakt- oder Erdungsbleches, an das ein aus dem Gehäuse 2 nach außen geführter Erdleiter 36 (FIG 1) kontaktiert wird. Das Erdungsblech ist dann in nicht näher dargestellter Art und Weise mit einem entsprechenden Erdleiteranschluß der Steckerkupplung 8 verbunden.

Das Unterteil 3 kann mit verschiedenen Steckerkupplungen 8, 8' für z.B. M12- bzw. M23-Stecker bestückt werden. An diese Steckerkupplungen 8, 8' können z.B. handelsübliche Rundkabel mit angegossenen Steckern bis zur Schutzart IP67 angeschlossen werden. Die elektrische Verbindung von der Steckerkupplung 8,8' zu den Kontaktspießen 11 erfolgt dann über das Verbindungsteil 25, das somit funktional ein Adapter ist.

Dabei werden als Kontaktelemente 26 gemäß FIG 5 bevorzugt Flachfederelemente 26a, Kelchfedern 26b oder Leiterabschnitte 26c verwendet werden. Der oder jeder Leiterabschnitt 26c ist dazu in einer Aufnahmenut 37 verlegt, die zweckmäßigerweise in der Ausnehmung 31 im Kontaktierungsbereich 12 des Unterteils 3 vorgesehen ist. Sie kann aber auch auf dem Verbindungsteil 25 vorgesehen sein.

Durch den Aufbau des Moduls 1 mit dem für einen Rundkabelanschluß ausgestalteten Unterteil 3 und mit dem darauf adaptierbaren Gehäuse 2 ergeben sich große Vorteile bezüglich Montage und Servicefreundlichkeit. Das Unterteil 3 kann an dessen Einsatzort fertig montiert werden. Anschließend kann entweder zunächst das Rundkabel mit der Steckerkupplung 8, 8' verbunden werden, oder es kann zunächst durch Verschwenken das Gehäuse 2 auf das Unterteil 3 aufgesetzt und durch Festziehen der Schraube 20 die Kontaktierung mit den Kontaktelementen 26 bewerkstelligt werden. Der Austausch von Gehäusen 2 zwecks Reparatur oder Verwendung einer Variante mit geänderter Elektronik läßt sich leicht durchführen, ohne daß hiervon das Unterteil 3 und die Kabelverlegung berührt sind. Zudem ermöglicht der Aufbau des Moduls 1 eine einfache Zerlegung in seine Komponenten, was für Reperaturen beispielsweise auch der Leiterplatte vorteilhaft ist.

## Patentansprüche

1. Modul zum Anschluß von Aktoren und/oder Sensoren, mit einem auf ein Unterteil (3) aufsetzbaren Gehäuse (2), das eine Kontaktierungseinrichtung mit Kontaktstiften (11) aufweist, **dadurch gekennzeichnet, daß** das Unterteil (3) ein das Gehäuse (2) überragendes Aufnahmeteil (7) mit einer Aufnahmeöffnung (10) aufweist, in der eine mit einem Verbindungsteil (25) elektrisch leitend verbundene Steckerkupplung (8, 8') eines Rundkabelanschlusses angeordnet ist, wobei das Verbindungsteil (25) mit den Kontaktstiften (11) in Eingriff bringbare Kontaktelemente (26) aufweist.

2. Modul nach Anspruch 1, **dadurch gekennzeichnet, daß** das Aufnahmeteil (7) an einem Freiende des Unterteils (3) angeformt und in Modullängsrichtung (9) konisch ausgebildet ist, wobei die Aufnahmeöffnung (10) quer zur Ebene des Unterteils (3) verläuft.

3. Modul nach Anspruch 2, **dadurch gekennzeichnet, daß** das Aufnahmeteil (7) an dessen konischem Freiende eine an die kreisrunde Aufnahmeöffnung (10) angepaßte Außenkontur aufweist.

4. Modul nach einem der Ansprüche 1 bis 3, **dadurch gekennzeichnet, daß** das Verbindungsteil (25) eine an das Unterteil (3) montierbare und die Steckerkupplung (8, 8') tragende Köntaktplatte ist, wobei den Kontaktelementen (26) korrespondierende Öffnungen (28) im Kontaktierungsbereich (12) des Unterteils (3) zugeordnet sind, durch die die Kontaktstifte (11) im Montagezustand zur Kontaktierung mit den Kontaktelementen (26) hindurdhgeführt sind.

5. Modul nach einem der Ansprüche 1 bis 4, **dadurch gekennzeichnet, daß** das oder jedes Kontaktelement (26) ein Federelement (26a, 26b) ist.

6. Modul nach einem der Ansprüche 1 bis 4, **dadurch gekennzeichnet, daß** das oder jedes Kontaktelement (26) ein Leiterabschnitt (26c) ist, der in einer im Kontaktierungsbereich (12) vorgesehenen Aufnahmenut (37) positioniert ist.

7. Modul nach einem der Ansprüche 1 bis 6, **dadurch gekennzeichnet, daß** im Unterteil (3) eine Ausnehmung (31) für eine Flachdichtung (32) zur Abdichtung des Kontaktierungsbereichs (12) vorgesehen ist.

8. Modul nach einem der Ansprüche 1 bis 7, **dadurch gekennzeichnet, daß** das Gehäuse (2) schwenkmontierbar auf dem Unterteils (3) gehalten ist.

9. Modul nach Anspruch 8, **dadurch gekennzeichnet, daß** als Schwenkmittel zur schwenkmontierbaren Halterung am Unterteil (3) angeformte Haken (14) sowie daran angepaßte und am Gehäuseoberteil (2) angeformte Einhängevorrichtungen (13) vorgesehen sind.

10. Modul nach einem der Ansprüche 1 bis 9, **dadurch gekennzeichnet, daß** das Unterteil (3) im Kontaktierungsbereich (12) mindestens eine an die Außenkontur eines Flachkabels angepaßte Aufnahmenut (33) mit Kontaktstiften (34) zur stirnseitigen Kontaktierung des Flachkabels aufweist.

11. Modul nach einem der Ansprüche 1 bis 10, **gekennzeichnet durch** eine mechanische Kodierung mit einem Kodierungsstecker (17) und mit einer von diesem getragenen Kodierbuchse (19), die im Anschluß an eine Erstmontage in einer korrespondierenden, vorzugsweise im Unterteil (3) vorgesehenen Öffnung (18) verbleibt.

12. Modul nach einem der Ansprüche 1 bis 11, **gekennzeichnet durch** eine Ausnehmung (35) zur Aufnahme eines Erdungsbleches.

## Claims

1. Module for connecting actuators and/or sensors, comprising a housing (2) which is mountable on a base (3), which has a contact unit with contact pins (11), **characterised in that** the base (3) has an accommodating element (7) which projects beyond the housing (2), said accommodating element having an aperture (10) in which a plug coupling (8, 8') (connected in an electrically conductive manner to a connector (25)) of a round cable connection is arranged, whereby the connector (25) has contact elements (26) that engage with the contact pins (11).

2. Module according to Claim 1, **characterised in that** the accommodating element (7) is moulded onto a free end of the base (3), the accommodating element having a conical shape in a longitudinal direction of the module (9), whereby the aperture (10) is positioned at a right angle to a plane of the base (3).

3. Module according to Claim 2, **characterised in that** the accommodating element (7) has an outer contour at its conical free end that matches a circular shape of the aperture (10).

4. Module according to one of Claims 1 to 3, **characterised in that** the connector (25) is a contact plate which is mountable on the base (3) and holds the plug coupling (8, 8'), whereby corresponding openings (28) in the contact area (12) of the base (3) are assigned to the contact elements (26), the contact pins (11) passing through the openings after assembly to establish contact with the contact elements (26).

5. Module according to one of Claims 1 to 4, **characterised in that** at least one of the contact elements (26) is a spring element (26a, 26b).

6. Module according to one of Claims 1 to 4, **characterised in that** at least one of the contact elements (26) is a conductor segment (26c) which is positioned in a retraining groove (37), said retaining groove being provided in the contact area. (12)

7. Module according to one of Claims 1 to 6, **characterised in that** the base (3) has a recess (31) for a flat gasket (32) for sealing the contact area (12).

8. Module according to one of Claims 1 to 7, **characterised in that** the housing (2) is held in a position where it can be swivel-mounted on the base (3).

9. Module according to Claim 8, **characterised in that** the base (3) includes moulded hooks (14) and an upper portion of the housing (2) includes attachment recesses (13) corresponding to the moulded hooks (14), the hooks and the attachment recesses forming a swivel means for positioning the housing so that the housing can be swivel-mounted on the base.

10. Module according to one of Claims 1 to 9, **characterised in that** a contact area (12) of the base (3) has at least one retaining groove (33) matching an outer contour of a flat cable with contact pins (34) for establishing contact with an end of the flat cable.

11. Module according to one of Claims 1 to 10, **characterised by** a mechanical coding mechanism including a coding plug (17) and a coding socket (19) held by the coding plug, the coding socket remaining in a corresponding opening (18), preferably in the base (3), following initial assembly.

12. Module according to one of Claims 1 to 11, **characterised in that** there is a recess (35) for holding an earthing plate.

## Revendications

1. Module de raccordement d'actionneurs et/ou de détecteurs comprenant un boîtier (2) qui peut être posé sur une partie (3) inférieure et qui comporte un dispositif de contact ayant des broches (11) de contact, **caractérisé en ce que** la partie (3) inférieure comporte une partie (7) de réception dépassant du boîtier (2) et ayant une ouverture (10) de reception, dans laquelle est disposé un couplage (8, 8') de connecteur dune borne de câble rond, ce couplage étant relié dune manière conductrice de l'électricité à une partie (25) de liaison, la partie (25) de liaison ayant des éléments (26) de contact qui peuvent venir en prise avec les broches (11) de contact.

2. Module suivant la revendication 1, **caractérisé en ce que** la partie (7) de réception est formée à une extrémité libre de la partie (3) inférieure et est constituée de manière conique dans la direction (9) longitudinale du module, l'ouverture (10) de réception s'étendant transversalement au plan de la partie (3) inférieure.

3. Module suivant la revendication 2, **caractérisé en ce que** la partie (7) de réception a à son extrémité libre conique un contour extérieur adapté à l'ouverture (10) circulaire de réception.

4. Module suivant Tune des revendications 1 à 3, **caractérisé en ce que** la partie (25) de liaison est une plaque de contact qui peut être montée sur la partie (3) inférieure et qui porte le couplage (8, 8') de connecteur et il est associé aux éléments (26) de contact des ouvertures (28) correspondantes ménagées dans la région (12) de contact de la partie (3) inférieure, ouvertures par lesquelles les broches (11) de contact passent à l'état monté pour assurer le contact avec les éléments (26) de contact.

5. Module suivant l'une des revendications 1 à 4, **caractérisé en ce que** l'élément (26) de contact ou chaque élément (26) de contact est un élément (26a, 26b) élastique.

6. Module suivant Tune des revendications 1 à 4, **caractérisé en ce que** l'élément (26) de contact ou chaque élément (26) de contact est un tronçon (26c) conducteur qui est mis en position dans une gorge (37) de réception prévue dans la région (12) de contact.

7. Module suivant Tune des revendications 1 à 6, **caractérisé en ce qu'**il est prévu dans la partie (3) inférieure un évidement (31) pour une garniture (32) plate d'étanchéité destinée à assurer l'étanchéité de la région (12) de contact.

8. Module suivant l'une des revendications 1 à 7, **caractérisé en ce que** le boîtier (12) est monté basculant sur la partie (3) inférieure.

9. Module suivant la revendication 8, **caractérisé en ce qu'**il est prévu comme moyen de basculement pour le montage basculant des crochets (14) formés sur la partie (3) inférieure ainsi que des dispositifs (13) d'accrochage qui y sont adaptés et qui sont formés sur la partie (2) supérieure du boîtier.

10. Module suivant l'une des revendications 1 à 9, **caractérisé en ce que** la partie (3) inférieure comporte dans la région (12) de contact au moins une gorge (33) de réception qui est adaptée au contour extérieur d'un câble plat et qui comprend des broches (34) de contact pour assurer du côté frontal le contact du câble plat.

11. Module suivant Tune des revendications 1 à 10, **caractérisé par** un codage mécanique comprenant une partie mâle (17) de codage et une douille (19) de codage portée par celui-ci, et restant à la suite d'un premier montage dans une ouverture (18) correspondante prévue de préférence dans la partie (3) inférieure.

12. Module suivant Tune des revendications 1 à 11, **caractérisé par** un évidement (35) de réception dune tôle de mise à la terre.
